# EUROPEAN PATENT SPECIFICATION

(11) **EP 0 898 173 B1**
(45) Date of publication and mention of the grant of the patent: **17.12.2003**
(21) Application number: 98111634.6
(22) Date of filing: 24.06.1998
(51) Int. Cl.: G01R 31/00

(54) **A device for detecting faults in an electric line of a vehicle, in particular a commercial vehicle**
Fehlerdetektionsanordnung für eine elektrische Leitung eines Fahrzeugs, insbesondere eines Nutzfahrzeugs
Dispositif pour détecter des fautes dans un conducteur électrique d'un véhicule, en particulier un véhicule commercial

(30) Priority: 25.06.1997 IT TO970558
(43) Date of publication of application: 24.02.1999
(73) Proprietor: IVECO FIAT S.p.A., 10156 Torino (IT)
(72) Inventor: Varalda, Orlando, 10151 Torino (IT)
(74) Representative: Gervasi, Gemma, Dr.

(56) References cited:
- DE-U- 8 526 253
- FR-A- 2 613 495
- US-A- 3 699 433
- US-A- 4 177 420
- US-A- 5 621 600

## Description

The present invention relates to a device for detecting faults in a electric line of a vehicle, in particular a commercial vehicle.

In road-going vehicles it is often difficult to trace the causes of faults occurring in the electric circuit. These difficulties occur to a greater extent in commercial vehicles because of the greater complexity of the electric circuit and the length of the electric lines supplying power to the different electrical equipment and devices.

Sometimes, even though the defective electric line is identified, it is not readily possible to trace the exact location of the fault. In these cases it is general practice to provide a by-pass along this line, i.e. by connecting an electric conductor cable in parallel with the defective cable.

However, in addition to not resolving the causes of the fault, the electric circuit is further complicated by the addition of additional cables.

US 5 621 600 A discloses an arrangement for locating short circuits in an electric line of a vehicle. A test signal is injected into the line and a magnetic field sensor is moved along the line to detect the test signal.

The object of the present invention is to provide a device for detecting faults in an electric line, which can be used advantageously for the diagnostic testing of the electric circuit of a commercial vehicle and which is able to locate accurately the faults themselves.

The present invention provides a device as defined by claim 1.

With a view to a better understanding of the present invention a preferred embodiment will be described non-restrictively by way of example below, with reference to the accompanying drawings, in which:
Figure 1a shows schematically a portion of the electric circuit of a commercial vehicle adapted to be tested diagnostically with the device according to the present invention;
Figures 1b and 1c illustrate a section of the electric circuit in Fig 1a, in which a first type and a second type of fault are present respectively;
Figure 2 shows a circuit diagram of one part of the device of the invention, and
Figure 3 shows a circuit diagram of another part of the device of the invention.

The device of the invention makes it possible to carry out a diagnostic test of the electric circuit of a vehicle by local monitoring of the electric field and of the magnetic field along the electric conductor lines of the electric circuit itself, thereby making it possible to locate any faults present.

Generally the electric circuit of a vehicle comprising a power supply battery, a transfer processor, a plurality of electric lines connecting the transfer processor to the electric consumer units of the vehicle (lights, geared motors for the windscreen wipers, etc.) for the power supply of the electric consumer units themselves, and a plurality of control devices (switches, deviators, etc.) which can be operated by the driver and which are interconnected with the processor to energise the respective electric lines. In the following description of the invention reference will be made, without thereby effecting any limitation, to a single electric consumer unit, to the associated electric line and to the associated control device, it being understood that any consideration can be applied to any electric line of the vehicle.

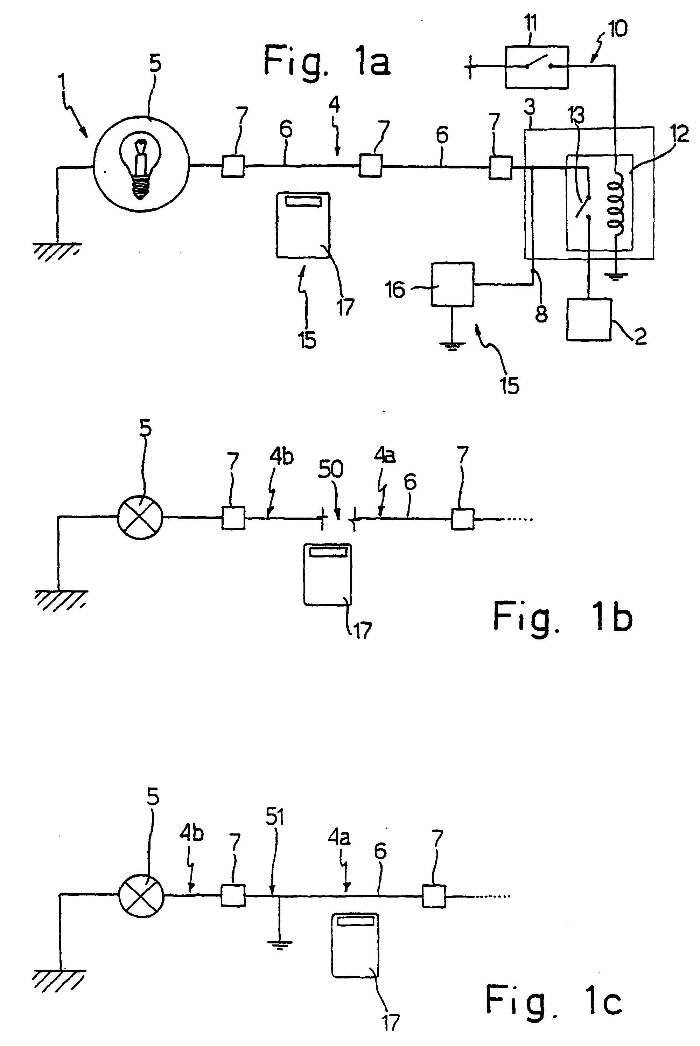

In Figure 1a the reference numeral 1 denotes an electric circuit (only part of which is shown as it is known) of a commercial vehicle (not shown). The electric circuit 1 comprises a power supply battery 2, a transfer processor 3 of known type connected to the power supply battery 2, an electric line 4 connecting the processor 3 to a remote electric consumer unit 5 (for example the lamp of a rear light of the vehicle) and a control circuit 10 associated with the electric line 4. The electric line 4 comprises a number of electric cables 6 connected in series to one another by electric connectors 7.

The processor 3 has an auxiliary terminal 8 accessible from the outside of the processor 3 and connected inside the processor 3 itself to the electric line 4.

The control circuit 10 comprises a switch 11, for example a manually operated switch, and a relay 12 provided in the transfer processor 3 and adapted to close, when the switch 11 is switched to the closed position, a further switch 13 adapted to connect the electric line 4 to the power supply battery 2.

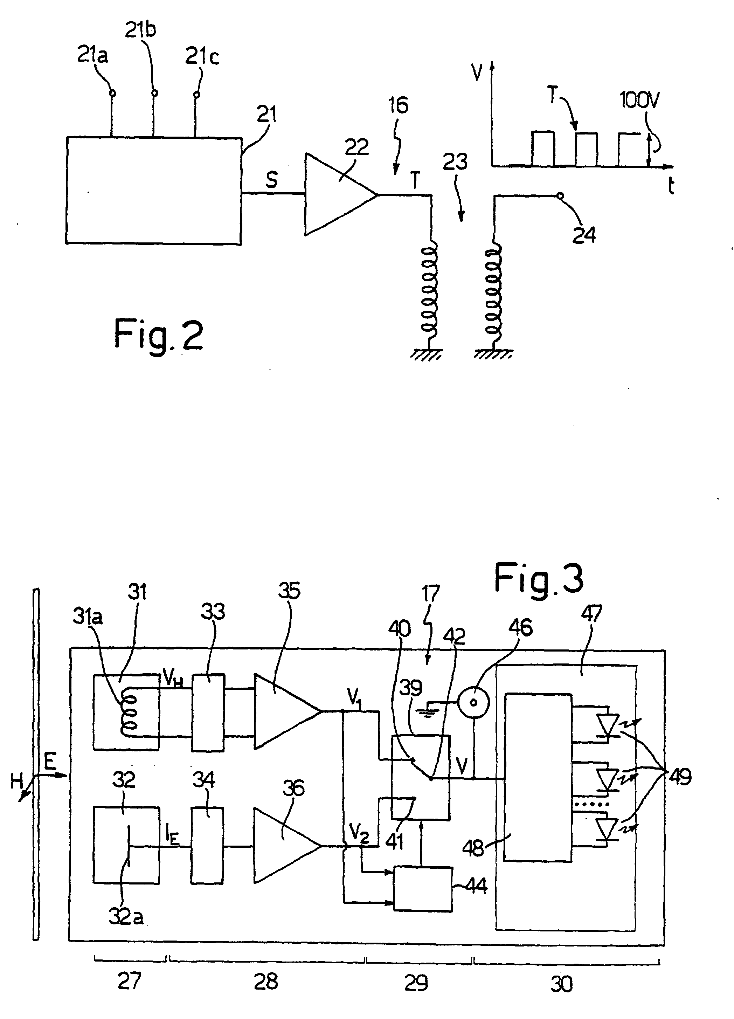

Still in Figure 1a, the reference numeral 15 denotes a fault detecting device forming the subject-matter of the present invention; the device 15 comprises a signal generator 16 and a signal detector 17. The signal generator 16 is constructed as will be described below with reference to Figure 2 and is adapted to be connected to the auxiliary terminal 8 of the electronic processor 3 so as to feed a test signal T to the electric line 4. The signal detector 17 is a portable apparatus, which will be described below with reference to Figure 3, and is adapted to be arranged in the vicinity of the electric line 4 and to be moved along the electric line 4 itself so as to interact electrically and magnetically therewith when the test signal T is passing through it.

Referring now to Figure 2, the signal generator 2 comprises a function generator 21 of known type and adapted to generate a periodic signal S, a power amplifier 22 connected to the output of the function generator 21 and adapted to amplify the signal S to obtain the test signal T with an amplitude of approximately of 100 V, and a galvanic decoupling transformer 23 interposed between the output of the power amplifier 22 and an output terminal 24 of the signal generator 16; in particular, the output terminal is adapted to be connected to the terminal 8 of the electronic processor 3 so as to feed the test signal T to the electric line 4.

The function generator 21 is provided with control inputs 21a, 21b, 21c for adjustment (in known manner and not shown as it is known) of the signal S and, therefore, of the test signal T. In particular, the function generator 21 comprises a first control input 21a for selection of the type of waveform (sinusoidal, square or triangular), a second control input 21b for adjustment of the frequency F of the signal S in the range comprised between a minium frequency F₁ (for example, equal to 1000 Hz) and a maximum frequency F₂ (for example, equal to 5000 Hz), and a third control input 21c for adjustment of the duty cycle FU associated with the signal S. The frequency of the signal S, normally set to about 3500 Hz, is varied in the case in which other parts of the electric circuit 1 have resonance effects which exactly correspond to said frequency, thereby causing the propagation of the test signal T in undesirable areas different from the electric line 4. On the other hand, the duty cycle FU is set so as to vary the energy associated with the signal T as a function of the length of the electric line to be tested diagnostically and so as to prevent possible damage to electronic components (not shown) operating at low power (microprocessors, for example) interconnected to the processor 3.

Referring now to Figure 3, the signal detector 17 comprises a detection stage 27, a filtering and amplifying stage 28, a comparison and commutation stage 29 and a signalling stage 30.

The detection stage 27 includes a magnetic field sensor 31, comprising a coil 31a adapted to effect inductive coupling with the electric line 4 to be tested diagnostically, and an electric field sensor 32, comprising a flat metal plate 32a adapted to effect capacitive coupling with the electric line 4.

In particular, the sensor 31 is adapted to generate an alternating voltage V_{H} correlated to the magnetic field strength H generated by the electric line 4 and to the distance at which said field is measured, i.e. to the distance of the coil 31a from monitored cable 6. On the other hand, the sensor 32 is adapted to generate an alternating current I_{E} correlated to the electric field strength E generated by the alternating voltage present in the cable 6 and to the distance between the plate 32a and the cable 6 itself.

The filtering and amplifying stage 28 comprises a pair of band-pass filters 33,34, with a band pass of between 1000 Hz and 5000 Hz, connected on the input side to the outputs of the magnetic field sensor 31 and the electric field sensor 32. The filtering and amplifying stage 28 further comprises a pair of amplifiers 35 and 36 of known type, the first of which is connected to the output of the filter 33 and the second of which is connected to the output of the filter 34; the amplifier 35 is of the voltage/voltage type and transforms the voltage V_{H} into a voltage V₁; the amplifier 36 of the current/voltage type and transforms the current I_{E} into a voltage V₂. In particular, the amplifiers 35 and 36 are designed to supply, when the electric line 4 is operating correctly, a voltage V₂ (associated, as already stated, with the electric field E) which is always greater than the voltage V₁ (associated with the magnetic field H).

The comparison and commutation stage 29 comprises a commutator 39, in which an output node 42 is alternately connected, based on the value of a two-level control signal C, to a first input node 40 connected to the output of the amplifier 35 or to a second input node 41 connected to the output of the amplifier 36. The comparison and commutation stage 29 also comprises a comparator 44 of known type adapted to compare the voltages V₁ and V₂ so as to generate the control signal C and feed it to the commutator 39. In particular, the comparator 44 generates a control signal C with a value with a value C₁ if V₁>V₂ and with a value C₂≠C₁ if V₁<V₂. In the first case (V₁>V₂), the commutator 39 connects the output 42 to the input 40 so as to have at the output 42 the voltage V₁, whereas in the second case (V₁<V₂), the commutator 39 connects the output 42 to the input 41 so as to have at the output 42 the voltage V₂. In practice, at the output 42 of the commutator 39 there is a voltage V equal to the highest of the two voltages V₁ and V₂ and, on the basis of what has been stated above, in the case in which the electric line 4 is operating correctly the voltage V will be equal to V₂.

The signalling stage 30 comprises an acoustic signalling device 46 and a visible indicator 37. The acoustic signalling device 46 is connected to the output node 42 of the commutator 39 and is adapted to emit a sound which of an intensity proportional to the voltage V. The visible indicator 47 is also connected to the output node 42 of the commutator 39 and comprises a level gauge 48 of known type connected on the output side to a group of luminous indicators 49 of LED type, arranged in a row so as to define a graduated luminous scale. In practice, the level gauge 48 effects, in a known manner, a comparison between the voltage V and series of gradually increasing threshold values each associated with a luminous indicator 48 [sic] and supplies current only to the luminous indicators 48 [sic] having a threshold value lower than the voltage V.

In operation, to test diagnostically the efficiency of the line 4, the signal generator 16 is connected, as shown in Figure 1a, to the auxiliary terminal 8. Before the test signal T is fed to the electric line 4, the latter is disconnected, if this has not already taken place, from the battery 2 by actuating the switch 11. The signal generator 16 is then activated so as to feed the test signal T to the line 4 through the auxiliary terminal 8.

Therefore, the signal detector 17 is arranged in the vicinity of the electric line 4 at a location close to the transfer processor 3 and it is subsequently moved, while still remaining close to the electric line 4, towards the electric consumer unit 5.

If the electric line 4 is without faults (Figure 1), after the test signal T has been applied, an electric field E and a magnetic field H are generated, the values of which are not negligible in the vicinity of the cable 6 over the entire length of the line 4. Therefore, the signal detector 17 detects along the entire line 4 the fields E and H and a number of luminous indicators (LED) 49 are illuminated on the visible indicator device 47 proportional to the strength of the electric field E (since, as already stated previously, in this situation V₁>V₂). At the same time, the acoustic signalling device 46 emits an acoustic signal of a strength proportional to the strength of the electric field E.

In the case, illustrated in Figure 1b, in which there is an interruption (indicated at 50) along the electric line 4, for example caused by the breakage of one of the cables 6 or by the disconnection of one the cables 6 from the respective connector 7, the electric field E will be present in the vicinity of the section of the line 4a which extends between the processor 3 and the interruption 50 and it will be substantially nil along the section of the line 4b which extends between the interruption 50 and the electric consumer unit 5, whereas the magnetic field H will be nil along the entire electric line 4 itself, because of the interruption in the current flow. In this situation the signal detector 17 will supply, upstream of the interruption 50, acoustic and luminous signals which are not nil and which are proportional to the strength of the electric field E, whereas downstream of the interruption 50, since both fields are nil, it will supply acoustic and luminous signals both of which are nil. If the signal detector 17 is moved continuously along the line 4, the interruption is readily located by the operator because level with said interruption there is an abrupt decrease both in the acoustic signal and in the luminous signal (in particular, this latter decrease is indicated by the gradual switching-off of all the LED).

If, as illustrated in Figure 1c, there is a short-circuit to earth (indicated by 51) along the line 4, the electric field E and the magnetic field H will be present in the vicinity of the section of line 4a which extends between the processor 3 and the short-circuit 51, and the electric field E and the magnetic field H will be both be substantially nil along the section of line 4b which extends between the short-circuit 51 and the electric consumer unit 5.

Even in such a situation the signal detector 17 will supply, upstream of the short-circuit 51, acoustic and luminous signals which are not nil and which are proportional to the most intense of the signals V₁ and V₂, whereas downstream of the short-circuit 51, since both the fields E and H are nil, it will supply acoustic and luminous signals both of which are nil. Even in this instance, if the signal detector 17 is moved continuously along the electric line 4, the fault (in this case the short-circuit 51) is readily located because level with said short-circuit there is an abrupt decrease both in the acoustic signal and in the luminous signal.

As is evident from the foregoing description, the device according to the invention makes it possible to locate in a simple, accurate and rapid manner any faults occurring in the electric circuit of a commercial vehicle.

Finally, it is evident that the fault-detecting device described and illustrated can be subject to modifications and variants which do not depart from the scope of protection, as defined by claim 1, of the present invention.

## Claims

1. A device for detecting faults in an electric line of a vehicle, in particular a commercial vehicle, comprising signal generating means (16) able to generate a test signal (T) and to feed said test signal (T) to said electric line (4), and signal detector means (17), arranged to be moved along and in the vicinity of said electric line, **characterised in that** said detector means are able to detect the electric and magnetic fields generated by said electric line (4) so as to detect said test signal ((T).

2. A device according to claim 1, **characterised in that** said signal generating means (16) comprise function generator means (21) adapted to generate said test signal (T) with periodic behaviour; said function generator means (21) being of adjustable type (21a) so as to generate different waveforms, in particular a sinusoidal, square or triangular waveform.

3. A device according to claim 1 or 2, **characterised in that** said signal generating means (16) comprise first adjustment means (21b) for varying the frequency of said test signal (T) between a minimum frequency value (F₁) and a maximum frequency value (F₂).

4. A device according to any one of the preceding claims, **characterised in that** said signal generating means (16) comprise second adjustment means (21c) for varying the duty cycle (FU) of said test signal.

5. A device according to any one of the preceding claims, **characterised in that** said detector means (17) comprise magnetic field sensor means (31) adapted to generate a first signal (V_{H}) linked to the magnetic field (H) associated with said test signal (T) passing through said electric line (4), and electric field sensor means (32) adapted to generate a second signal (I_{E}) linked to the electric field (E) associated with said test signal (T) passing through said electric line (4).

6. A device according to claim 5, **characterised in that** said magnetic field sensor means (31) comprise inductive coupling means (31a) adapted to be coupled inductively with said electric line (4) so as to generate said first signal (V_{H}), and **in that** said electric field sensor means (32) comprise capacitive coupling means (32a) adapted to be coupled in a capacitive manner with said electric line (4) so as to generate said second signal (I_{E}).

7. A device according to claim 5 or 6, **characterised in that** said detector means (17) comprise visible signalling means (47) adapted to generate a visible signal correlated alternately with the strength of said electric field (E) or of said magnetic field (H), and acoustic signalling means (46) adapted to generate an acoustic signal, the strength of which is linked alternately with the strength of the electric field (E) or with the strength of the magnetic field (H) associated with said test signal (T) passing through said electric line (4).

8. A device according to claim 7, **characterised in that** said visible signalling means (47) comprise a graduated luminous scale.

9. A device according to claim 7 or 8, **characterised in that** said detector means (17) comprise automatic commutation means (39,44) interposed between said magnetic field and electric field sensor means (31,32) and said visible and acoustic signalling means (47,46) and adapted to connect alternately and automatically an output node (42) communicating with said visible and acoustic signalling means (47,46) to a first input node (40) connected to said magnetic field sensor means (31) or to a second input node (41) connected to said electric field sensor means (32).

## Patentansprüche

1. Vorrichtung zum Nachweisen von Fehlern in einer elektrischen Leitung eines Fahrzeugs, insbesondere eines Nutzfahrzeugs, welche umfasst: Signalerzeugungsmittel (16), welche imstande sind, ein Testsignal (T) zu erzeugen und das genannte Testsignal (T) in die genannte elektrische Leitung (4) einzuspeisen, und Signalnachweismittel (17), welche so angeordnet sind, dass sie längs der genannten elektrischen Leitung und in der Nähe derselben bewegt werden können, **dadurch gekennzeichnet, dass** die genannten Nachweismittel imstande sind, das elektrische und das magnetische Feld nachzuweisen, welche durch die genannte elektrische Leitung (4) erzeugt werden, so dass das genannte Testsignal (T) nachgewiesen wird.

2. Vorrichtung gemäß Anspruch 1, **dadurch gekennzeichnet, dass** die genannten Signalerzeugungsmittel (16) Funktionsgeneratormittel (21) umfassen, die so ausgelegt sind, dass sie das genannte Testsignal (T) mit einem periodischen Verhalten erzeugen, wobei die genannten Funktionsgeneratormittel (21) dergestalt vom einstellbaren Typ (21a) sind, dass sie unterschiedliche Wellenformen, insbesondere eine sinusförmige, quadratische oder dreieckförmige Wellenform, erzeugen.

3. Vorrichtung gemäß Anspruch 1 oder 2, **dadurch gekennzeichnet, dass** die genannten Signalerzeugungsmittel (16) erste Einstellmittel (21b) zur Veränderung der Frequenz des genannten Testsignals (T) zwischen einem minimalen Frequenzwert (F₁) und einem maximalen Frequenzwert (F₂) umfassen.

4. Vorrichtung gemäß einem der vorherigen Ansprüche, **dadurch gekennzeichnet, dass** die genannten Signalerzeugungsmittel (16) zweite Einstellmittel (21c) zur Veränderung des Tastgrades (FU) des genannten Testsignals umfassen.

5. Vorrichtung gemäß einem der vorherigen Ansprüche, **dadurch gekennzeichnet, dass** die genannten Nachweismittel (17) umfassen: Magnetfeld-Sensormittel (31), welche so ausgelegt sind, dass sie ein erstes Signal (V_{H}) erzeugen, welches mit dem Magnetfeld (H) verknüpft ist, das mit dem genannten, durch die genannte elektrische Leitung (4) tretenden Testsignal (T) im Zusammenhang steht, und Sensormittel für das elektrische Feld (32), welche so ausgelegt sind, dass sie ein zweites Signal (I_{E}) erzeugen, welches mit dem elektrischen Feld (E) verknüpft ist, das mit dem genannten, durch die genannte elektrische Leitung (4) tretenden Testsignal (T) im Zusammenhang steht.

6. Vorrichtung gemäß Anspruch 5, **dadurch gekennzeichnet, dass** die genannten Magnetfeld-Sensormittel (31) induktive Kopplungsmittel (31a) umfassen, welche so ausgelegt sind, dass sie an die genannte elektrische Leitung (4) induktiv angekoppelt werden, so dass sie das genannte erste Signal (V_{H}) erzeugen, und dadurch, dass die genannten Sensormittel für das elektrische Feld (32) kapazitive Kopplungsmittel (32a) umfassen, welche so ausgelegt sind, dass sie an die genannte elektrische Leitung (4) auf kapazitive Weise angekoppelt werden, so dass sie das genannte zweite Signal (I_{E}) erzeugen.

7. Vorrichtung gemäß Anspruch 5 oder 6, **dadurch gekennzeichnet, dass** die genannten Nachweismittel (17) umfassen: Mittel zur visuellen Signalanzeige (47), welche so ausgelegt sind, dass sie ein visuelles Signal erzeugen, welches wechselweise mit der Stärke des genannten elektrischen Feldes (E) oder des genannten Magnetfeldes (H) in Beziehung gebracht wird, und Mittel zur akustischen Signalanzeige (46), welche so ausgelegt sind, dass sie ein akustisches Signal erzeugen, dessen Intensität wechselweise mit der Stärke des elektrischen Feldes (E) oder mit der Stärke des Magnetfeldes (H) in Beziehung gebracht wird, die mit dem genannten, durch die genannte elektrische Leitung (4) tretenden Testsignal (T) im Zusammenhang stehen.

8. Vorrichtung gemäß Anspruch 7, **dadurch gekennzeichnet, dass** die genannten Mittel zur visuellen Signalanzeige (47) eine graduierte Leuchtskala umfassen.

9. Vorrichtung gemäß Anspruch 7 oder 8, **dadurch gekennzeichnet, dass** die genannten Nachweismittel (17) automatische Umschaltmittel (39, 44) umfassen, welche zwischen die genannten Sensormittel (31, 32) für das Magnetfeld und das elektrische Feld und die genannten Mittel (47, 46) für die visuelle und akustische Signalanzeige geschaltet und so ausgelegt sind, dass sie wechselweise und automatisch einen Ausgangsknotenpunkt (42), der mit den genannten Mitteln (47, 46) für die visuelle und akustische Signalanzeige verbunden ist, mit einem ersten Eingangsknotenpunkt (40), der mit den genannten Magnetfeld-Sensormitteln (31) verbunden ist, oder mit einem zweiten Eingangsknotenpunkt (41), der mit den genannten Sensormitteln (32) für das elektrische Feld verbunden ist, in Verbindung bringt.

## Revendications

1. Dispositif pour détecter des défauts dans une ligne électrique d'un véhicule, en particulier un véhicule commercial, comprenant des moyens générateurs de signaux (16) aptes à produire un signal test (T) et à transmettre ledit signal test (T) à ladite ligne électrique (4), et des moyens de détection de signaux (17), agencés pour être déplacés le long et au voisinage de ladite ligne électrique, **caractérisé en ce que** lesdits moyens de détection sont aptes à détecter les champs électriques et magnétiques produits par ladite ligne électrique (4) de manière à détecter ledit signal test (T).

2. Dispositif selon la revendication 1, **caractérisé en ce que** lesdits moyens générateurs de signaux (16) comprennent des moyens générateurs de fonction (21) aptes à produire ledit signal test (T) avec un comportement périodique ; lesdits moyens générateurs de fonction (21) étant du type ajustable (21a) de manière à produire des formes d'onde différentes, en particulier une forme d'onde sinusoïdale, carrée ou triangulaire.

3. Dispositif selon la revendication 1 ou 2, **caractérisé en ce que** lesdits moyens générateurs de signaux (16) comprennent des premiers moyens d'ajustement (21b) pour faire varier la fréquence dudit signal test (T) entre une valeur de fréquence minimale (F₁) et une valeur de fréquence maximale (F₂).

4. Dispositif selon l'une des revendications précédentes, **caractérisé en ce que** lesdits moyens générateurs de signaux (16) comprennent des seconds moyens d'ajustement (21c) pour faire varier le rapport cyclique (FU) dudit signal test.

5. Dispositif selon l'une des revendications précédentes, **caractérisé en ce que** lesdits moyens de détection (17) comprennent des moyens de détection de champs magnétiques (31) aptes à produire un premier signal (V_{H}) lié au champ magnétique (H) associé audit signal test (T) passant à travers ladite ligne électrique (4), et des moyens de détection de champs électriques (32) aptes à produire un deuxième signal (I_{Z}) lié au champ électrique (E) associé audit signal test (T) passant à travers ladite ligne électrique (4).

6. Dispositif selon la revendication 5, **caractérisé en ce que** lesdits moyens de détection de champs magnétiques (31) comprennent des moyens de couplage inductifs (31a) aptes à être couplés d'une manière inductive à ladite ligne électrique (4) de manière à produire ledit premier signal (V_{H}), et **en ce que** lesdits moyens de détection de champs électriques (32) comprennent des moyens de couplage capacitifs (32a) aptes à être couplés d'une manière capacitive à ladite ligne électrique (4) de manière à produire ledit deuxième signal (I_{Z}).

7. Dispositif selon la revendication 5 ou 6, **caractérisé en ce que** lesdits moyens de détection (17) comprennent des moyens de signalisation visibles (47) conçus pour produire un signal visible alternativement en corrélation avec la force dudit champ électrique (E) ou dudit champ magnétique (H), et des moyens de signalisation acoustique (46) apte à produire un signal acoustiques dont la force est liée alternativement à la force du champ électrique (E) ou à la force du champ magnétique (H) associé audit signal test (T) passant à travers ladite ligne électrique (4).

8. Dispositif selon la revendication 7, **caractérisé en ce que** lesdits moyens de signalisation visibles (47) comprennent une échelle lumineuse graduée.

9. Dispositif selon la revendication 7 ou 8, **caractérisé en ce que** lesdits moyens de détection (17) comprennent des moyens de commutation automatiques (39, 44) interposés entre lesdits moyens de détection de champs magnétiques et de champs électriques (31, 32) et lesdits moyens de signalisation visibles et acoustiques (47, 46) et conçus pour connecter alternativement et automatiquement un noeud de sortie (42) communiquant avec lesdits moyens de signalisation visibles et acoustiques (47, 46) à un premier noeud d'entrée (40) connecté auxdits moyens de détection de champs magnétiques (31) ou à un deuxième noeud d'entrée (41) connecté auxdits moyens de détection de champs électriques (32).
